# EUROPEAN PATENT APPLICATION

(11) **EP 4 535 033 A1**
(43) Date of publication of application: **09.04.2025**
(21) Application number: 24167998.4
(22) Date of filing: 02.04.2024
(51) Int. Cl.: G01S 7/52, G01S 7/524, G01S 15/10, G01S 15/12

(54) **ULTRASONIC DISTANCE SENSOR AND METHOD OF MEASURING LOCATION OF OBJECT USING ULTRASONIC DISTANCE SENSOR**

(30) Priority: 06.10.2023 KR 20230133103
(71) Applicant: Samsung Electronics Co., Ltd., Suwon-si, Gyeonggi-do 16677 (KR)
(72) Inventor: PARK, Sang Yun, 16677 Suwon-si (KR); KHANG, Seung Tae, 16677 Suwon-si (KR); KO, Byung Hoon, 16677 Suwon-si (KR); NOH, Seung Woo, 16677 Suwon-si (KR); CHOI, Jin Woo, 16677 Suwon-si (KR)
(74) Representative: Elkington and Fife LLP

(57) **Abstract**

An ultrasonic distance sensor is provided. The ultrasonic distance sensor according to an embodiment includes: a signal generator configured to generate a frequency-modulated continuous ultrasonic signal array; a gating switch configured to perform time gating to allow part of ultrasonic signals in the continuous ultrasonic signal array to pass therethrough; a transmitter configured to emit ultrasonic signals, having passed through the gating switch, toward an object; a receiver configured to receive an echo signal reflected from the object; and a signal processor configured to measure a location of the object by using the echo signal.

## Description

### FIELD OF THE INVENTION

Example embodiments of the disclosure relate to an ultrasonic distance sensor and a method of measuring a location of an object by using the ultrasonic distance sensor.

### BACKGROUND OF THE INVENTION

In a distance measurement method using an ultrasonic sensor, ultrasonic waves are generated and incident on an object, and a distance to the object is measured by calculating time taken for the ultrasonic waves to reflect back from the object. The distance measurement method using an ultrasonic sensor is performed with simple and relatively inexpensive equipment, and is mostly used indoors for measuring a position of obstacles and/or a distance to obstacles. However, the distance measurement method has a limited measurement distance and resolution. The speed and energy of ultrasonic waves of a typical ultrasonic sensor are changed depending on the properties of sound propagation in air or other medium, thereby causing an error in distance measurement.

### SUMMARY OF THE INVENTION

According to an aspect of an example embodiment of the disclosure, there is provided an ultrasonic distance sensor including: a signal generator configured to generate a continuous ultrasonic signal array that is frequency modulated; a gating switch configured to perform time gating to allow part of ultrasonic signals in the continuous ultrasonic signal array to pass through the gating switch; a transmitter configured to emit the ultrasonic signals, having passed therethrough, toward an object; a receiver configured to receive an echo signal reflected from the object; and a signal processor configured to measure a location of the object by using the echo signal.

The signal generator may be configured to generate respective ultrasonic signals by performing frequency modulation in a unit of a pulse width, the pulse width being set based on a target resolution.

The gating switch may be configured to perform synchronous time gating in the unit of the set pulse width to pass one ultrasonic signal through the gating switch.

In this case, the one ultrasonic signal may include an ultrasonic signal that is first in order in the continuous ultrasonic signal array.

In addition, the ultrasonic distance sensor may further include a first mixer configured to mix the continuous ultrasonic signal array with the echo signal to output a first mixed signal.

The signal processor may be configured to measure the location of the object by performing frequency analysis on the first mixed signal through Fast Fourier transform (FFT).

In addition, the ultrasonic distance sensor may further include a first analog-to-digital converter (ADC) configured to convert the first mixed signal into a digital signal and configured to transmit the digital signal to the signal processor.

In addition, the ultrasonic distance sensor may further include a signal delayer configured to delay the continuous ultrasonic signal array, generated by the signal generator, by a predetermined time period and configured to output the delayed ultrasonic signal array.

The signal delayer may delay the continuous ultrasonic signal array by half a pulse width of an ultrasonic signal.

In addition, the ultrasonic distance sensor may further include a second mixer configured to mix the continuous ultrasonic signal array, delayed by the signal delayer, with the echo signal to output a second mixed signal, wherein the signal processor may be configured to measure the location of the object based on a first frequency analysis result of the first mixed signal and a second frequency analysis result of the second mixed signal.

The signal processor may be configured to determine a location, commonly indicated in the first frequency analysis result and the second frequency analysis result, as the location of the object.

The signal processor may be configured to determine the location of the object based on a result of multiplying an amplitude of the first frequency analysis result by an amplitude of the second frequency analysis result.

In addition, the ultrasonic distance sensor may further include: a first ADC configured to convert the first mixed signal into a first digital signal and configured to transmit the first digital signal to the signal processor; and a second ADC configured to convert the second mixed signal into a second digital signal and configured to transmit the second digital signal to the signal processor.

In addition, a plurality of pairs of the transmitters and receivers may be provided, wherein the signal processor may be configured to reconstruct a multi-dimensional space by using the plurality of pairs of transmitters and receivers.

According to an aspect of an example embodiment of the disclosure, there is provided a method of measuring a location of an object by using an ultrasonic distance sensor, the ultrasonic distance sensor comprising a signal generator, a gating switch, a transmitter, a receiver, and a signal processor, the method including: generating, by using the signal generator, a continuous ultrasonic signal array that is frequency modulated; performing, by using the gating switch, time gating to allow part of ultrasonic signals in the continuous ultrasonic signal array to pass through the gating switch; emitting, by using the transmitter, the ultrasonic signals, which are allowed to pass through the gating switch, toward an object; receiving, by using the receiver, an echo signal reflected from the object; and measuring, by using the signal processor, a location of the object by using the echo signal.

In addition, the method may further include mixing the continuous ultrasonic signal array with the echo signal to output a first mixed signal.

The measuring the location of the object may include measuring the location of the object by performing frequency analysis on the first mixed signal through Fast Fourier transform (FFT).

In addition, the method may further include delaying the continuous ultrasonic signal array by a predetermined time period and outputting the delayed ultrasonic signal array.

In addition, the method may further include mixing the continuous ultrasonic signal array with the echo signal to output a second mixed signal, wherein the measuring the location of the object may include measuring the location of the object based on a first frequency analysis result of the first mixed signal and a second frequency analysis result of the second mixed signal.

According to an aspect of an example embodiment of the disclosure, there is provided a device including: an ultrasonic distance sensor configured to measure a location of an object; and a processor configured to perform an operation of the device by using the measured location of the object, wherein the ultrasonic distance sensor may include: a signal generator configured to generate a continuous ultrasonic signal array that is frequency modulated; a gating switch configured to perform time gating to allow part of ultrasonic signals in the continuous ultrasonic signal array to pass through the gating switch; a transmitter configured to emit ultrasonic signals, having passed through the gating switch, toward the object; a receiver configured to receive an echo signal reflected from the object; and a signal processor configured to measure the location of the object by using the echo signal.

### BRIEF DESCRIPTION OF THE DRAWINGS

The above and other aspects, features, and advantages of certain example embodiments of the disclosure will be more apparent from the following description taken in conjunction with the accompanying drawings.
FIGS. 1A and 1B are block diagrams illustrating an ultrasonic distance sensor according to example embodiments of the present disclosure.
FIGS. 2A and 2B are diagrams explaining examples of driving an ultrasonic distance sensor according to example embodiments of the present disclosure.
FIG. 3 is a block diagram illustrating an ultrasonic distance sensor according to an example embodiment of the present disclosure.
FIG. 4 is a diagram explaining an example of measuring a location of an object according to an example embodiment of the present disclosure.
FIGS. 5A and 5B are diagrams explaining an example of reconstructing a multi-dimensional space by using a plurality of pairs of transmitters and receivers.
FIG. 6 is a flowchart illustrating a method of measuring a location of an object according to an example embodiment of the present disclosure.
FIG. 7 is a flowchart illustrating a method of measuring a location of an object according to an example embodiment of the present disclosure.
FIG. 8 is a block diagram illustrating a device including an ultrasonic distance sensor according to an example embodiment of the present disclosure.
FIGS. 9A to 9C are diagrams illustrating examples of devices including an ultrasonic distance sensor.

### DETAILED DESCRIPTION

Details of example embodiments are included in the following detailed description and drawings. Advantages and features of the disclosure, and a method of achieving the same will be more clearly understood from the following example embodiments described in detail with reference to the accompanying drawings. Throughout the drawings and the detailed description, unless otherwise described, the same drawing reference numerals will be understood to refer to the same elements, features, and structures.

It will be understood that, although the terms, such as "first," "second," etc., may be used herein to describe various elements, these elements should not be limited by these terms. These terms are only used to distinguish one element from another. Any references to singular may include plural unless expressly stated otherwise. In addition, unless explicitly described to the contrary, an expression such as "comprising" or "including" will be understood to imply the inclusion of stated elements but not the exclusion of any other elements. Also, the terms, such as "unit" or "module," etc., should be understood as a unit that performs at least one function or operation and that may be embodied as hardware, software, or a combination thereof.

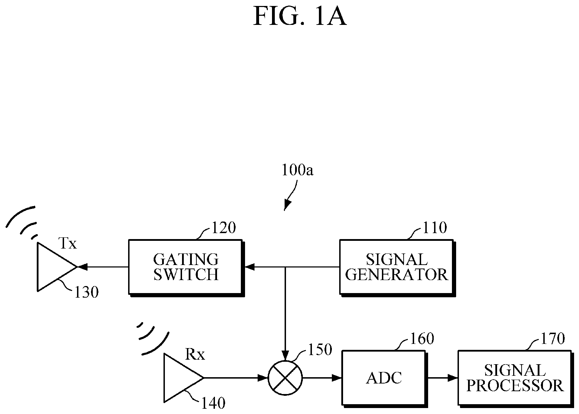

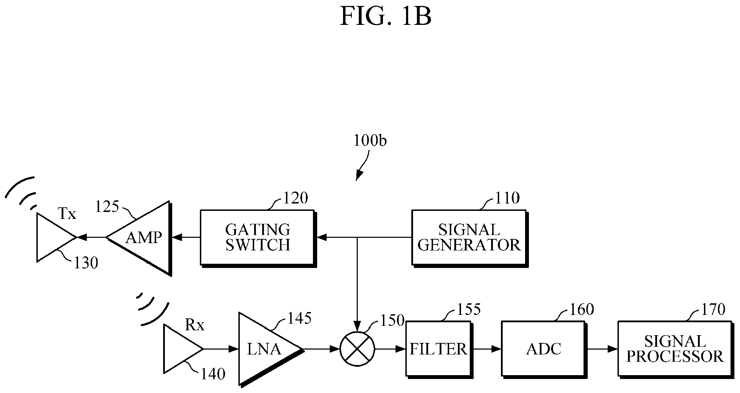

FIGS. 1A and 1B are block diagrams illustrating an ultrasonic distance sensor according to example embodiments of the present disclosure.

Referring to FIG. 1A, an ultrasonic distance sensor 100a includes a signal generator 110, a gating switch 120, a transmitter 130, a receiver 140, a mixer 150, an analog-to-digital Converter (ADC) 160, and a signal processor 170. Referring to FIG. 1B, an ultrasonic distance sensor 100b may further include a power amplifier (AMP) 125, a low noise amplifier (LNA) 145, and a filter 155. The respective components may be implemented as hardware or software, or a combination thereof.

The signal generator 110 may generate a frequency-modulated continuous ultrasonic signal array. A frequency bandwidth may be preset in consideration of a target resolution and the like, and an ultrasonic signal having a predetermined period (or a pulse width) may be generated according to the preset frequency bandwidth. In consideration of characteristics of the ultrasonic distance sensor 100a, the frequency bandwidth may be set to a relatively low frequency bandwidth, compared to typical Frequency-Modulated Continuous Wave (FMCW) distance measurement systems.

The gating switch 120 may perform synchronous time gating to allow only part of ultrasonic signals in the ultrasonic signal array, generated by the signal generator 110, to pass therethrough. For example, by performing time gating in units of pulse widths, the gating switch 120 may allow only one ultrasonic signal (e.g., first ultrasonic signal in order) in the ultrasonic signal array to pass therethrough. However, the gating switch 120 is not limited thereto, and may be configured to continuously or discontinuously allow two or more chirp signals to pass therethrough.

In an embodiment, the ultrasonic signal, having passed through the gating switch 120, may be amplified by the AMP 125 and transmitted to the transmitter 130, as illustrated in FIG. 1B.

The transmitter 130 may emit the ultrasonic signal, having passed through the gating switch 120, toward an object, and the receiver 140 may receive an echo signal reflected from the object. The transmitter 130 and the receiver 140 may include piezoelectric transducers. Each of the transmitter 130 and the receiver 140 may be formed by combining independent elements and/or components. A channel including a pair of one transmitter 130 and one receiver 140 may be formed, or multi-channels including pairs of one or more transmitters 130 and a plurality of receivers 140 or including pairs of a plurality of transmitters 130 and one or more receivers 140 may be formed. The transmitter 130 and the receiver 140 of each channel may be formed separately, or may be integrated into one package.

The ultrasonic signal array generated by the signal generator 110 may be sequentially input to the mixer 150 to be mixed with the echo signal received by the receiver 140. In an embodiment, the received echo signal may be amplified by the LNA 145 to be input to the mixer 150.

The mixed signal output from the mixer 150 may be converted by the ADC 160 into a digital signal to be input to the signal processor 170. In an embodiment, as illustrated in FIG. 1B, the mixed signal may be filtered through the filter 155 such that a sum frequency component between the ultrasonic signal array and the echo signal may be removed, and a beat frequency signal, having a difference frequency component between the ultrasonic signal array and the echo signal, may be transmitted to the ADC 150. The filter 155 may include a low pass filter, a band pass filter, and the like.

The signal processor 170 may measure a location of an object by using a beat frequency. For example, the signal processor 170 may calculate a distance to an object, may detect a new object and/or obtain information such as a moving speed of an object, and the like, by using the beat frequency. The signal processor 170 may perform Fast Fourier Transformation (FFT) on the beat frequency to measure a location of an object based on the frequency analysis result.

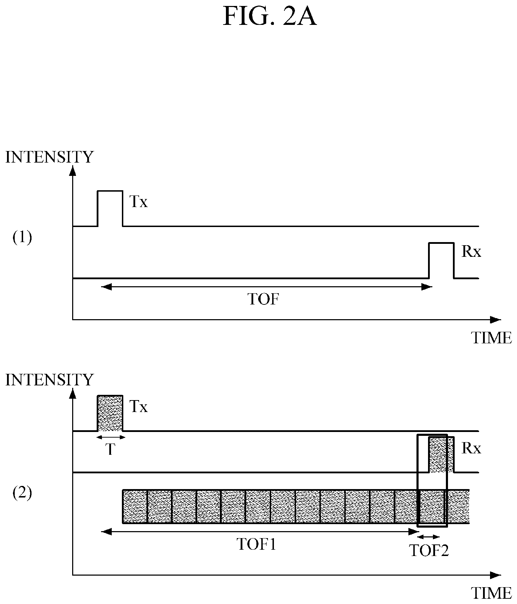

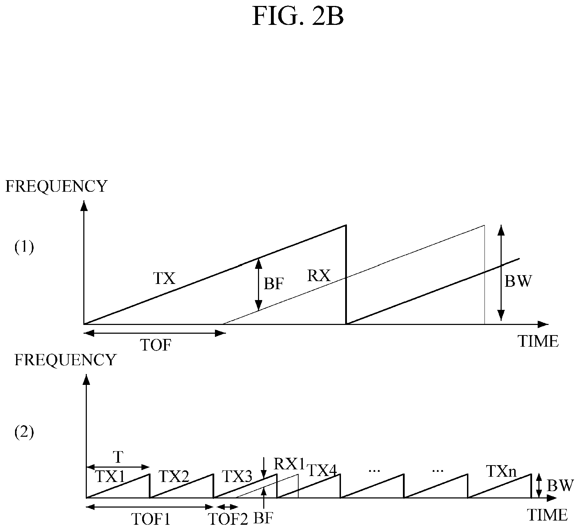

FIGS. 2A and 2B are diagrams explaining examples of driving an ultrasonic distance sensor according to example embodiments of the present disclosure.

In FIG. 2A, (1) illustrates a typical Time-Of-Flight (TOF) distance measurement method, and (2) illustrates a TOF distance measurement method according to an example embodiment of the present disclosure. In the TOF distance measurement method, depending on the size of a pulse width, a signal-to-noise ratio worsens, and a distance resolution is degraded. In FIG. 2B, (1) illustrates a typical FMCW distance measurement method, and (2) illustrates an FMCW distance measurement method according to an example embodiment of the present disclosure. Referring to (2) of FIG. 2A and (2) of FIG. 2B, according to example embodiments, a frequency-modulated continuous ultrasonic signal array is generated, but only one ultrasonic signal TX is emitted to an object by performing time gating in units of pulse widths (T), and the ultrasonic signal TX is mixed with an echo signal RX reflected from the object, such that frequency analysis is performed based on a tone frequency. A mixing pattern MX is divided into an interval TOF1 in which the echo signal is not detected and an interval TOF2 in which the echo signal is detected. By measuring the tone frequency based on a frequency difference between the echo signal and the ultrasonic signal in the interval TOF2 in which the echo signal is detected, computing resources required for analysis algorithms may be reduced, and a gain in a frequency bandwidth BW may be achieved, compared to the typical FMCW distance measurement method.

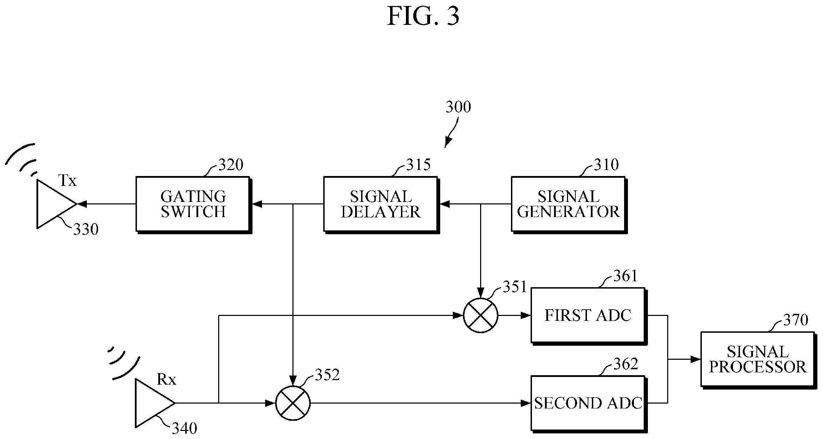

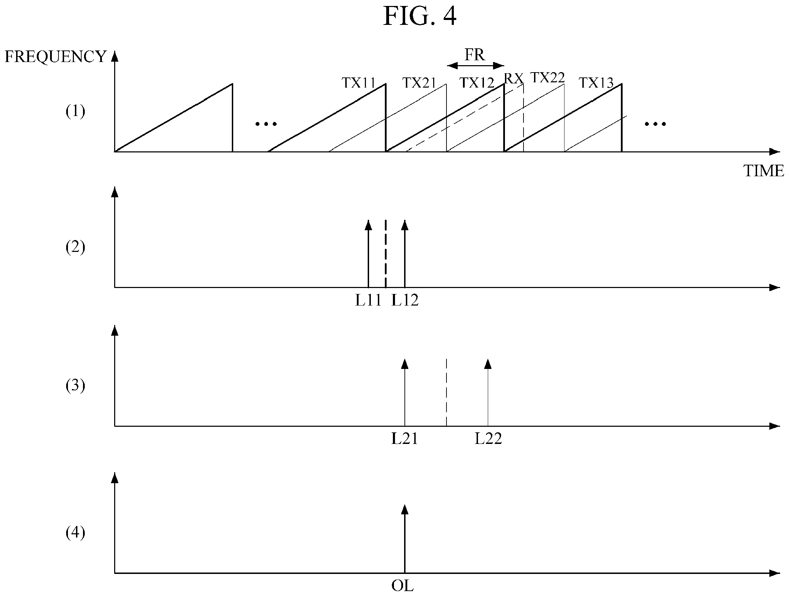

FIG. 3 is a block diagram illustrating an ultrasonic distance sensor according to an example embodiment of the present disclosure. FIG. 4 is a diagram explaining an example of measuring a location of an object according to an example embodiment of the present disclosure.

Referring to FIG. 3, an ultrasonic distance sensor 300 includes a signal generator 310, a signal delayer 315, a gating switch 320, a transmitter 330, a receiver 340, a first mixer 351, a second mixer 352, a firstADC 361, a second ADC 362, and a signal processor 370. In addition, the ultrasonic distance sensor 300 may further include an AMP, LNA, and a filter, although not shown in FIG. 3.

The signal generator 310 may generate a frequency-modulated ultrasonic signal array. The respective ultrasonic signals of the ultrasonic signal array may be frequency-modulated according to a frequency bandwidth preset in consideration of a target resolution and the like, and may be generated in predetermined units of pulse widths.

The signal delayer 315 may delay the ultrasonic signal array, generated by the signal generator 310, by a predetermined time period, and may output the delayed ultrasonic signal array. In this case, the delay time may be a time corresponding to half a pulse width, but is not limited thereto.

The gating switch 320 may perform synchronous time gating to pass only part of ultrasonic signals in the ultrasonic signal array output by the signal delayer 315 in a manner delayed by a predetermined time period. In this case, a chirp signal that is allowed to pass may be a first ultrasonic signal, which is first in order in the ultrasonic signal array.

The transmitter 330 may emit the ultrasonic signal, having passed through the gating switch 320, toward an object, and the receiver 340 may receive an echo signal reflected from the object. One or more transmitters 330 and one or more receivers 340 may form a pair, and the transmitter 330 and the receiver 340 may be formed separately or may be integrated into one package.

The first mixer 351 may output a first mixed signal by mixing the ultrasonic signal array, output from the signal generator 310, with the echo signal output from the receiver 340. The first mixed signal may be converted by the first ADC 361 into a digital signal and may be input to the signal processor 370.

The second mixer 352 may output a second mixed signal by mixing the echo signal with the ultrasonic signal array output by the signal delayer 315 in a manner delayed by a predetermined time period. The second mixed signal may be converted by the second ADC 362 into a digital signal and may be input to the signal processor 370.

The signal processor 370 may measure a location of the object by using the first mixed signal and the second mixed signal.

Referring to (1) of FIG. 4, an ultrasonic signal array TX11, TX12, TX13, ... generated by the signal generator 310 and an ultrasonic signal array TX21, TX22, ... delayed by the signal delayer 315 are input to the first mixer 351 and the second mixer 352, respectively, and are mixed with an echo signal RX reflected from an object and received by the receiver 340. Frequency analysis is performed on the first mixed signal from the first mixer 351 and the second mixed signal from the second mixer 352 in a frequency analysis interval FR through Fast Fourier transform (FFT), and a location, which is commonly indicated in frequency analysis results of the first and second mixed signals, may be determined as a final location of the object.

In FIG. 4, (2) illustrates an FFT spectrum for the first mixed signal obtained by mixing the ultrasonic signal array TX11, TX12, TX13, ... with the echo signal RX, and locations L11 and L12 may be measured based on the FFT spectrum. In FIG. 4, (3) illustrates an FFT spectrum for the second mixed signal obtained by mixing the delayed ultrasonic signal array TX21, TX22, ... with the echo signal RX, and locations L21 and L22 may be measured based on the FFT spectrum. As illustrated in (4) of FIG. 4, among the locations L11 and L12 measured using the first mixed signal and the locations L21 and L22 measured using the second mixed signal, a location OL that is commonly indicated by the locations L12 and L21 may be determined as a final object location. In an embodiment, by directly multiplying an amplitude of a frequency analysis result of the first mixed signal by an amplitude of a frequency analysis result of the second mixed signal, a location with a largest value may be determined as a final object location. However, determining the object location is not limited thereto.

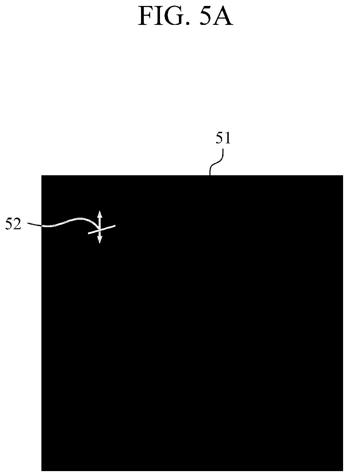

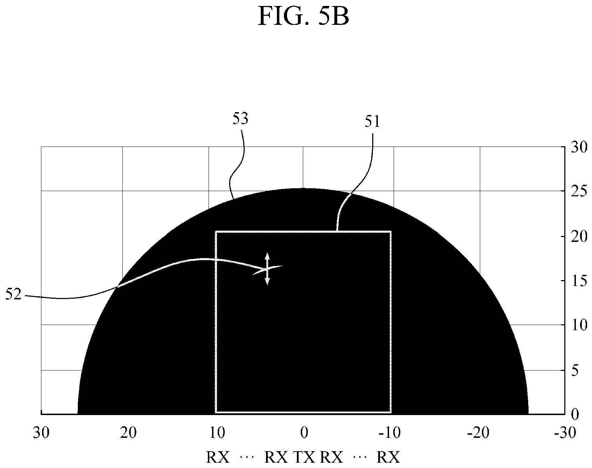

If the ultrasonic distance sensors 100a, 100b, and 300 according to example embodiments include pairs of the transmitters 130 and 330 and the receivers 330 and 340, the signal processors 170 and 370 may measure the location of an object and may reconstruct a multi-dimensional space by using the pairs of the transmitters 130 and 330 and the receivers 330 and 340. FIGS. 5A and 5B are diagrams illustrating a two-dimensional space reconstructed for an object 52 located in a 20 cm x 20 cm space 51, by using a transmitter TX located at an x-coordinate of 0 and a plurality of receivers RX located at x-coordinates in a range from -10 to 10. The signal processors 170 and 370 may also measure the speed and angle of an object and the like in the Doppler FFT domain by using the pairs of the transmitters 130 and 330 and the receivers 330 and 340.

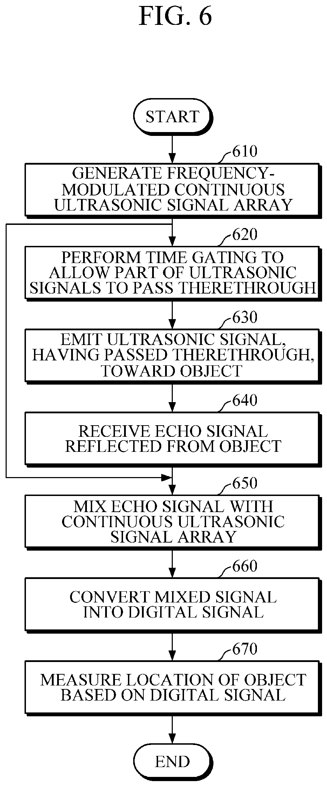

FIG. 6 is a flowchart illustrating a method of measuring a location of an object by using an ultrasonic distance sensor according to an example embodiment of the present disclosure. The method of FIG. 6 is an example of a method of measuring an object location which is performed by the ultrasonic distance sensors 100a and 100b of FIGS. 1A and 1B, and thus will be briefly described below.

The ultrasonic distance sensors 100a and 100b may generate a frequency-modulated continuous ultrasonic signal array in 610. A frequency bandwidth of a chirp signal may be determined in predetermined units of pulse widths by considering characteristics of the ultrasonic distance sensors, a target resolution, and the like. In this case, a predetermined frequency band may be set to a relatively low frequency band, compared to typical Frequency-Modulated Continuous Wave (FMCW) distance measurement systems.

Then, the ultrasonic distance sensors 100a and 100b may perform synchronous time gating to allow only part of ultrasonic signals in the ultrasonic signal array, generated in operation 610, to pass therethrough in 620. By performing time gating in units of pulse widths, the ultrasonic distance sensors 100a and 100b may pass, for example, a first-order ultrasonic signal in the ultrasonic signal array.

Subsequently, the ultrasonic distance sensors 100a and 100b may emit the ultrasonic signal, having passed therethrough, toward an object in 630. In this case, the ultrasonic distance sensors 100a and 100b may amplify the ultrasonic signal in 630.

Next, the ultrasonic distance sensors 100a and 100b may receive an echo signal reflected from the object in 640.

Then, the ultrasonic distance sensors 100a and 100b may mix the ultrasonic signal array, generated in operation 610, with the received echo signal in 650. The mixed signal is filtered by a low pass filter, a band pass filter, etc., such that a sum frequency component between the chirp signal array and the echo signal may be removed, and a beat frequency signal, having a difference frequency component between the chirp signal array and the echo signal, may be output.

Subsequently, the ultrasonic distance sensors 100a and 100b may convert the mixed signal into a digital signal in 660, and may measure a location of the object by performing frequency analysis on the mixed signal through Fast Fourier Transformation in 670.

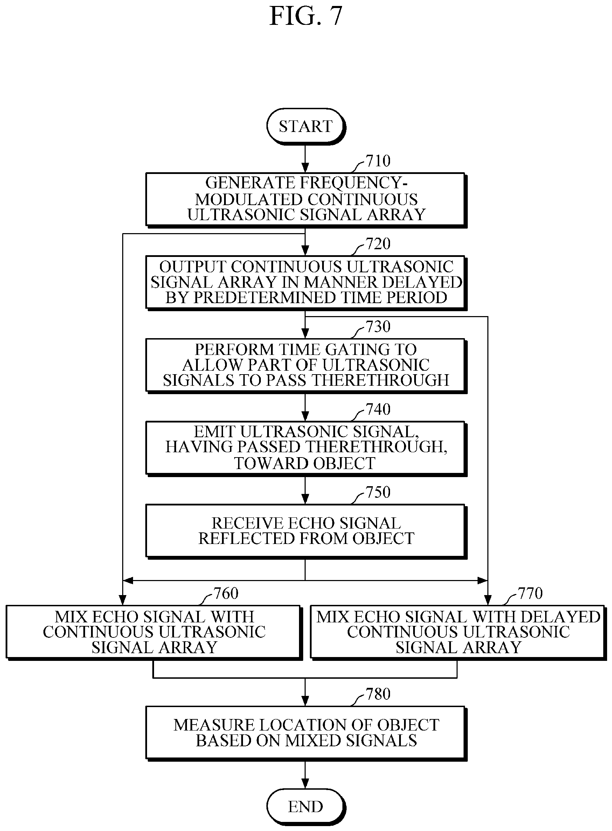

FIG. 7 is a flowchart illustrating a method of measuring a location of an object by using an ultrasonic distance sensor according to an example embodiment of the present disclosure. The method of FIG. 7 is an example of a method of measuring an object location which is performed by the ultrasonic distance sensor 300 of FIG. 3, and thus will be briefly described below.

The ultrasonic distance sensor 300 may generate a frequency-modulated continuous ultrasonic signal array in 710. The generated ultrasonic signal array may be output in a manner delayed by a predetermined time period in 720. The delay time may be a time corresponding to half a pulse width, but is not limited thereto.

Then, the ultrasonic distance sensor 300 may perform synchronous time gating to allow only part of ultrasonic signals in the ultrasonic signal array, output in a delayed manner, to pass therethrough in 730.

Subsequently, the ultrasonic distance sensor 300 may emit the ultrasonic signal, having passed therethrough, toward an object in 740, and may receive an echo signal reflected from the object in 750.

Next, the ultrasonic distance sensor 300 may mix the ultrasonic signal array generated in operation 710 and the ultrasonic signal array delayed in operation 720 with the received echo signal in 760 and 770, respectively.

Then, the ultrasonic distance sensor 300 may measure a location of the object in 780 by using the signals mixed in operations 760 and 770. The ultrasonic distance sensor 300 may measure a location of the object by performing frequency analysis on each of the mixed signals, and may determine a commonly indicated location of frequency analysis results as a final object location.

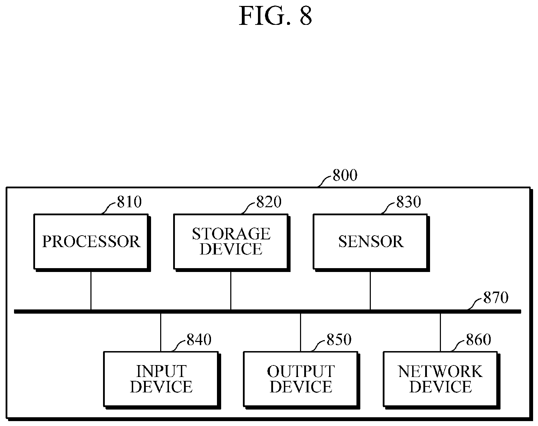

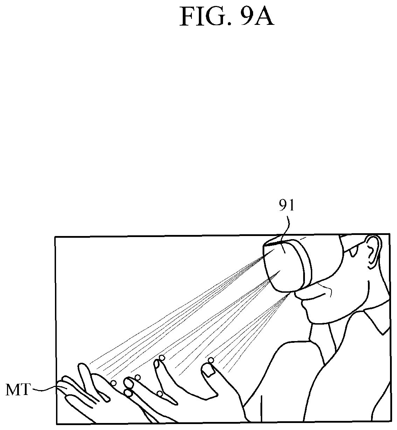

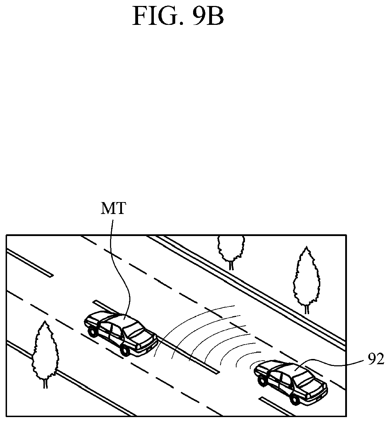

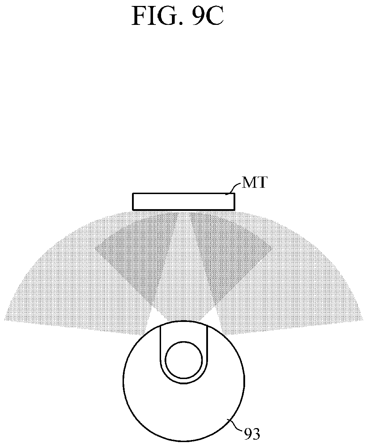

FIG. 8 is a block diagram illustrating a device including an ultrasonic distance sensor according to an example embodiment of the present disclosure. FIGS. 9A to 9C are diagrams illustrating examples of devices including an ultrasonic distance sensor.

A device 800 may include any one of the ultrasonic distance sensors 100a, 100b, and 300 described above and may perform operations and functions of any one of the ultrasonic distance sensors 100a, 100b, and 300. The device 800 may be used in an autonomous driving system, a flight radar system, a driver assistance system, an object recognition system, or surveillance and/or security system, and the like. The device 800 may be mounted in, for example, an image processing device, a radar device, a smartphone, a wearable device, a tablet computer, a netbook, a laptop, a desktop computer, a head mounted display (HMD), an autonomous and smart vehicle, a virtual reality (VR) device, an augmented reality (AR) device, an eXtended reality (XR) device, a vehicle, a mobile robot, and the like.

The device 800 may include a processor 810, a storage device 820, a sensor 830, an input device 840, an output device 850, and a network device 860. The processor 810, the storage device 820, the sensor 830, the input device 840, the output device 850, and the network device 860 may communicate with each other through a communication bus 870.

The processor 810 may execute functions and instructions to be performed in the device 800. For example, the processor 810 may process instructions stored in the storage device 820. The processor 810 may perform one or more operations described above.

The storage device 820 may store information or data to be used in processing operations of the processor 810. The storage device 820 may store instructions to be executed by the processor 810. The storage device 820 may include a computer-readable storage medium, e.g., a random access memory (RAM), a dynamic random access memory (DRAM), a static random access memory (SRAM), a magnetic hard disk, an optical disk, a flash memory, an electrically programmable read only memory (EPROM), or other types of computer readable storage media.

The sensor 830 may include one or more sensors. For example, the sensor 830 may include any one of the aforementioned ultrasonic distance sensors 100a, 100b, and 300, a radar sensor, an image sensor, and the like.

The input device 840 may receive a user input of one or more types, for example, a tactile or haptic input, a video, an audio, or a touch input. The input device 840 may include any other device capable of detecting an input from an input interface such as a keyboard, a mouse, a touch screen, a microphone, or a user and transmitting the detected input.

The output device 850 may provide an output of the computing device 800 to a user, for example, by a visual, auditory, or haptic method. For example, the output device 850 may include a liquid crystal display, a light emitting diode (LED) display, a touch screen, a speaker, a vibration generator, or any other device capable of providing the output to the user. The output device 850 may provide a result, in which object location information estimated by the ultrasonic distance sensor 810 is reflected, to the user in one of various formats, for example, by using one or more of visual information, auditory information, and haptic information.

The network device 860 may communicate with an external device through a wired and/or wireless network. For example, the network device 860 may communicate with an external device by using various wired and/or wireless communication techniques, such as Bluetooth communication, Bluetooth low energy (BLE) communication, near field communication (NFC), wireless local area network (WLAN) communication, Zigbee communication, infrared data association (IrDA) communication, wireless-fidelity (Wi-Fi) direct (WFD) communication, ultra-wideband (UWB) communication, Ant+ communication, Wi-Fi communication, radio frequency identification (RFID) communication, 3G, 4G, and 5G communications, direct connection via an internal bus, and the like.

Referring to FIGS. 9A to 9C, examples of the device 800 including the ultrasonic distance sensor described above may include a portable device 91, such as a virtual reality (VR) device, an augmented reality (AR) device, an eXtended reality (XR) device, etc., a vehicle 92, a mobile robot 93, and the like. As illustrated herein, the devices 91, 92, and 93 may recognize a front object MT and/or measure a distance to the object, and may perform operations by using the recognized and/or measured information, thereby providing corresponding services (e.g., AR, VR, and/or XR user experience) or functions such as autonomous driving and the like.

The present disclosure may be realized as a computer-readable code written on a computer-readable recording medium. The computer-readable recording medium may be any type of a recording device in which data is stored in a computer-readable manner.

Examples of the computer-readable recording medium include a ROM, a RAM, a CD-ROM, a magnetic tape, a floppy disc, an optical data storage, and a carrier wave (e.g., data transmission through the Internet). The computer-readable recording medium may be distributed over a plurality of computer systems connected to a network so that a computer-readable code is written thereto and executed therefrom in a decentralized manner. Functional programs, codes, and code segments needed for realizing the disclosure may be readily inferred by a person of ordinary skill in the art to which the disclosure pertains.

The present disclosure has been described herein with regard to example embodiments. However, it will be obvious to those skilled in the art that various changes and modifications may be made without changing technical conception and essential features of the present disclosure. Thus, it is clear that the above-described embodiments are illustrative in all aspects and are not intended to limit the present disclosure.

## Claims

1. An ultrasonic distance sensor comprising:
a signal generator configured to generate a continuous ultrasonic signal array that is frequency modulated;
a gating switch configured to perform time gating to allow part of ultrasonic signals in the continuous ultrasonic signal array to pass through the gating switch;
a transmitter configured to emit ultrasonic signals, having passed through the gating switch, toward an object;
a receiver configured to receive an echo signal reflected from the object; and
a signal processor configured to measure a location of the object by using the echo signal.

2. The ultrasonic distance sensor of claim 1, wherein the signal generator is configured to generate respective ultrasonic signals by performing frequency modulation in a unit of a pulse width, the pulse width being set based on a target resolution.

3. The ultrasonic distance sensor of claim 2, wherein the gating switch is configured to perform synchronous time gating in the unit of the set pulse width to pass one ultrasonic signal through the gating switch.

4. The ultrasonic distance sensor of claim 3, wherein the one ultrasonic signal comprises an ultrasonic signal that is first in order in the continuous ultrasonic signal array.

5. The ultrasonic distance sensor of any preceding claim, further comprising a first mixer configured to mix the continuous ultrasonic signal array with the echo signal to output a first mixed signal, and optionally wherein the signal processor is configured to measure the location of the object by performing frequency analysis on the first mixed signal through Fast Fourier transform, FFT.

6. The ultrasonic distance sensor of claim 4 or 5, further comprising a first analog-to-digital converter, ADC, configured to convert the first mixed signal into a digital signal and configured to transmit the digital signal to the signal processor.

7. The ultrasonic distance sensor of any of claims 4 to 6, further comprising a signal delayer configured to delay the continuous ultrasonic signal array, generated by the signal generator, by a predetermined time period and configured to output the delayed ultrasonic signal array, and optionally wherein the signal delayer configured to delay the continuous ultrasonic signal array by a time corresponding to half a pulse width of an ultrasonic signal.

8. The ultrasonic distance sensor of claim 7, further comprising a second mixer configured to mix the continuous ultrasonic signal array, delayed by the signal delayer, with the echo signal configured to output a second mixed signal,
wherein the signal processor is configured to measure the location of the object based on a first frequency analysis result of the first mixed signal and a second frequency analysis result of the second mixed signal, and optionally wherein the signal processor is configured to determine a location, commonly indicated in the first frequency analysis result and the second frequency analysis result, as the location of the object.

9. The ultrasonic distance sensor of claim 8, wherein the signal processor is configured to determine the location of the object based on a result of multiplying an amplitude of the first frequency analysis result by an amplitude of the second frequency analysis result.

10. The ultrasonic distance sensor of claim 8 or 9, further comprising:
a first ADC configured to convert the first mixed signal into a first digital signal and configured to transmit the first digital signal to the signal processor; and
a second ADC configured to convert the second mixed signal into a second digital signal and configured to transmit the second digital signal to the signal processor.

11. The ultrasonic distance sensor of any preceding claim, wherein a plurality of pairs of transmitters and receivers are provided, and
wherein the signal processor is configured to reconstruct a multi-dimensional space by using the plurality of pairs of transmitters and receivers.

12. A device comprising:
an ultrasonic distance sensor according to any preceding claim configured to measure a location of an object; and
a processor configured to perform an operation of the device by using the measured location of the object.

13. A method of measuring a location of an object by using an ultrasonic distance sensor, the ultrasonic distance sensor comprising a signal generator, a gating switch, a transmitter, a receiver, and a signal processor, the method comprising:
generating, by using the signal generator, a continuous ultrasonic signal array that is frequency modulated;
performing, by using the gating switch, time gating to allow part of ultrasonic signals in the continuous ultrasonic signal array to pass through the gating switch;
emitting, by using the transmitter, ultrasonic signals, which are allowed to pass through the gating switch, toward an object;
receiving, by using the receiver, an echo signal reflected from the object; and
measuring, by using the signal processor, a location of the object by using the echo signal.

14. The method of claim 13, further comprising mixing the continuous ultrasonic signal array with the echo signal to output a first mixed signal, and optionally wherein the measuring the location of the object comprises measuring the location of the object by performing frequency analysis on the first mixed signal through Fast Fourier transform, FFT.

15. The method of claim 14, further comprising delaying the continuous ultrasonic signal array by a predetermined time period and outputting the delayed ultrasonic signal array, and optionally further comprising mixing the continuous ultrasonic signal array with the echo signal to output a second mixed signal,
wherein the measuring the location of the object comprises measuring the location of the object based on a first frequency analysis result of the first mixed signal and a second frequency analysis result of the second mixed signal.
